# EUROPEAN PATENT SPECIFICATION

(11) **EP 1 694 103 B1**
(45) Date of publication and mention of the grant of the patent: **10.10.2007**
(21) Application number: 06110146.5
(22) Date of filing: 20.02.2006
(51) Int. Cl.: H05K 1/02, H05K 1/18, H05K 3/30

(54) **Method for implanting an electronic component on a support in order to increase resistance of the assembly to repeated impacts and vibrations and system comprising said component and support**
Verfahren für die Bestückung eines elektronischen Komponentes auf eine Auflage um den Widerstand des Aufbaus gegen widerholte Stösse und Erschütterungen zu erhöhen und System umfassend solch ein Komponent und Auflage
Procédé d'implantation d'un composant électronique sur un support de sorte à augmenter la résistance de l'assemblage à des chocs et vibrations répétés et système comprenant lesdits composant et support

(30) Priority: 22.02.2005 FR 0501765
(43) Date of publication of application: 23.08.2006
(73) Proprietor: MAGNETI MARELLI FRANCE, 92000 Nanterre (FR)
(72) Inventor: Aujay, Olivier, 86100 Chatellerault (FR); Grohando, Claude, 86100 Chatellerault (FR)
(74) Representative: Texier, Christian

(56) References cited:
- EP-A- 0 696 880
- US-A- 5 426 568
- US-A1- 2004 134 680
- PATENT ABSTRACTS OF JAPAN vol. 016, no. 084 (E-1172), 28 February 1992 (1992-02-28) -& JP 03 270030 A (HITACHI LTD), 2 December 1991 (1991-12-02)

## Description

The field of the invention is that of components intended to be implanted into an electronic interconnection support. More specifically, the invention relates to the mounting of electronic components of the SMC (surface mounted components) type, on an electronic board, the whole being subject to a severe mechanical environment and more particularly to an environment with repeated vibrations and impacts.

The invention is notably applied but not exclusively to the field of the automotive industry, of electronics and on-board electronics.

In automotive use, for example the electronic boards including an interconnection support and electronic components are subject to severe mechanical environments. The attained vibration levels generate mechanical stresses which may have significant consequences on their operation and on the assembly of surface mounted components on the interconnection support.

In particular, surface mounted components are directly mounted on the electronic board by solder on their conducting contacts. Often, these solder joints which provide the electrical connections are the only mechanical means used for securing the SMC type component to the electronic board.

Now, one of the main problems in an environment of repeated vibrations and impacts relates to the strength of the solder joints.

In particular, a chemical capacitor only assembled with an electronic board through both of its conducting pads vibrates like a pendulum. If severe resonance is attained, the movements of the electronic component generate mechanical fatigue of its electrical pins or terminals.

It may thus be mechanically destroyed or may malfunction if it is not installed so as to meet the requirements due to the environments in which automobiles have to operate, i.e., an environment with repeated vibrations, impacts or acceleration.

These not very favourable conditions require means which alleviate the stresses to which are subject the solder joints of the electrical contact in order to prevent their fatigue and failure.

To this day, several techniques for assembling a surface mounted component on an electronic board are known, which strengthen the resistance of the whole to severe mechanical environments.

A first known assembling technique applies mechanical means. To reduce the problem related to vibrations, it proposes that mechanical cohesion of the SMC type components be provided by mechanical reinforcing parts (generally with a spring effect) mounted on the electronic boards. The use of special cases may be mentioned for electronic components provided with mechanical holding pins or even the use of mechanical reinforcing parts by clipping them on or riveting them.

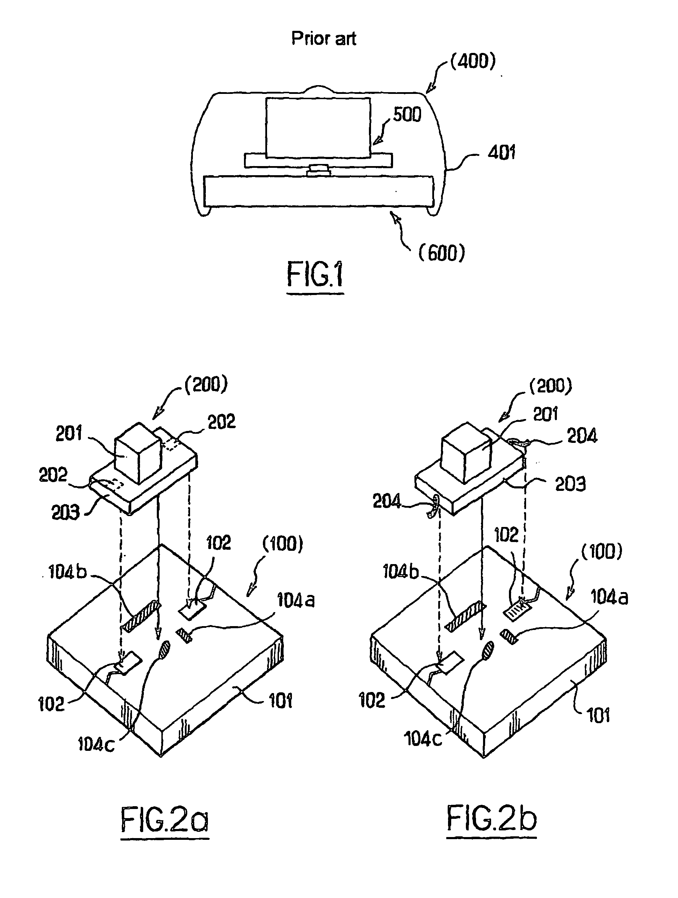

An exemplary embodiment of an assembly of a SMC type component on an electronic board by means of a mechanical holding clip according to the state of the art is illustrated in the appended Fig. 1. The mechanical holding clip 400 is preferably positioned near the centre of gravity of the surface mounted electronic component 500. Its prongs 401 come into contact with the lower portion of the electronic board 600 in order to effectively hold the electronic component on the electronic board.

The mechanical means, as illustrated by the holding clip of Fig. 1, effectively reduce mechanical perturbations generated by repeated vibrations and impacts and reinforce the resistance of the whole to these severe environments.

However, they have drawbacks. Indeed, their mass is not insignificant. However, the mass constraint often is a dimensioning parameter for electronic applications.

Moreover, these mechanical reinforcing parts have a well defined shape and necessarily occupy a certain surface area on the electronic board, which reduces the possibilities of implanting electronic components and complicates the making of the circuit.

A second known technique associates the use of specific pads of the support, without any electrical function, exclusively dedicated to the soldering on the body of the component and of special casings adapted so as to allow such soldering of the component. The main drawback of this technique comes from the fact that the casings specially designed for this purpose have a cost which is not insignificant.

A third known assembly technique is based on depositing one or more adhesive spots on the printed circuit so as to stick the SMC type components on their future locations, generally on the solder "side", and on depositing solder paste on the electrical connection receiving pads of the printed circuit. The electronic components are bound by the adhesive portion on the circuit and the whole is transferred into a high temperature oven in order to completely polymerise the adhesive. The whole is then transferred into a final means for soldering SMC type components by melting the solder paste which binds the conducting pads of the printed circuit to the electrical terminals of the electronic component.

Another known technique applies simple adhesive bonding without any solder. Adhesive bonding consists of achieving intimate chemical contact between two solids by means of a third body. The gap between the component and the support is thereby completed with structural adhesive. The adhesive is generally a thermosetting epoxy resin. It forms a continuous joint between both components through which mechanical forces are transmitted perfectly.

The gain in weight as compared with the mechanical techniques listed earlier is also an important asset, particularly for applications to the automotive and aerospace industry.

However, in a market which requires increasingly more performance for a minimum of costs, both of these prior art techniques appear to be complex, not very economical and not very productive.

Indeed, their drawbacks partly result from the fact that the assembly operations involve the solution of many problems. The preparation of the surface of the items to be stuck may be mentioned, i.e. the application of adequate physico-chemical treatments to the surfaces of the printed circuit and the electronic component, costly operations but indispensable for removing contaminants, increasing the energy of the surface, increasing mechanical adherence by creating rough features, and promoting wetting in order to facilitate spreading of the adhesive.

Proper selection of the adhesive product according to many criteria related to the actual nature of the components to be assembled, to the conditions to which the assembly will be subject, to the wettability characteristics of the adhesive, to the conditions and to the solidification time, the drying time (adhesive-setting time) or the polymerization time may be mentioned.

On the other hand, in the assembling technique with one or several adhesive spots, polymerization is a relatively slow step to apply, which exposes the assembly to high temperatures during significant time. It is well known from the prior art that this promotes the growth of intermetallics, particularly the tin-lead intermetallic, which embrittle the solder joints. Surface mounted components such as chemical capacitors, sensitive to severe thermal environments, may be deteriorated or destroyed.

As for the adhesive joint made by the adhesive bonding technique, by means of thermosetting materials, disassembly for repairing electronic components is an operation which of course cannot be contemplated without deteriorating the components.

It is noted that problems similar to those identified above are posed during the assembly of the surface mounted component on the electronic board by a last known technique for depositing a retaining sealant, adhesive or varnish, after soldering electronic components. On the other hand, encapsulation of these components may also give rise to problems of durability. Indeed, in the long term, resins which are used for encapsulation, for example, tend to have microcracks which let through external fluids, notably water, and they are the origin of corrosion in encapsulated metal components and of occurrence of short circuits.

The prior art comprises document US-A1-2004/0134680 describing an assembly that is provided having a first circuit board and a second circuit board, each circuit board having a plurality of electrical connection points, electrical connection points on the first circuit board being connected to specified electrical connection points on the second circuit board by solder structures, the first and second circuit boards being stacked with respect to each other and with a defined standoff distance there between, the assembly comprising one or more stops having an inserted portion placed between the first and second circuit board along the perimeter of at least one of the electrical circuit boards, and the inserted portion of each of the stops having a fixed, predetermined height.

Notably the invention has the purpose of finding a remedy to the drawbacks of the prior art.

An object of the invention is to provide a technique for mounting a SMC type component on an electronic board which minimizes the effect of the sources of external vibrations on the assembly of the surface mounted component with the interconnection support of the electronic board. More specifically, an object of the invention is to provide an implantation of a surface mounted component on an electronic board which increases the resistance of the whole to repeated vibrations and impacts.

It is also desirable to provide a technique for mounting a SMC type component on the interconnection support on an electronic board, with which, on the one hand, easy, fast, automated implantation of electronic components may be achieved while using standard components available in SMC technology and electronic manufacturing processes controlled today by surface mounting technology and, on the other hand, obvious savings in terms of cost, weight, construction and design may be achieved without compromising in any way the resistance of the whole to repeated vibrations and impacts.

Another object of the present invention is to propose an implantation of electronic components on the interconnection support of an electronic card very resistant to repeated vibrations and impacts, which provides the possibility of separating the assembly components for steps intended to repair soldered joints and faulty components.

These objects as well as other objects which will appear in the following, are achieved by a method according to claim 1 for implanting at least one electronic component on an interconnection support of an electronic board, provided with electrical connection receiving pads includes a step for mechanically holding said electronic component on said interconnection support, characterized in that it said mechanical holding step being achieved by at least depositing solder on at least one solderable holding pad, distinct from the electrical connection and solder receiving pads on the electronic component and, by positioning said electronic component on said support so that said additional solderable holding pad comes at least partly into contact with a non-solderable area of said electronic component, so as to provide mechanical cohesion of the assembly in a severe mechanical environment on the one hand and to obtain a strong resistance of the assembly to repeated vibrations and/or impacts on the other hand.

Advantageously, the solderable holding pads of such an implantation are positioned outside the middle axis passing through the electrical connection receiving pads.

It is also an object of the present invention to provide a system according to claim 9.

After assembly, according to the invention, the electronic component is mechanically held by solder or conducting adhesive joints on the electrical connection receiving pads on the one hand and in a non-solderable area of its sole by menisci of solders located on the solderable holding pads, on the other hand.

The invention will be better understood and other advantages will become apparent upon reading the description which follows, given as a non-limiting example and by means of the appended drawings wherein:
- Fig. 1 already described in connection with the prior art illustrates the assembling of a surface mounted component on an electronic board by means of a mechanical retaining clip.
- Figs. 2a and 2b illustrate views of the upper surface of the electronic board according to the invention before assembling two surface mounted components provided with electrical terminals and electrical pins, respectively.
- Fig. 3 schematically illustrates the location of a surface mounted component on the different solderable pads of the upper surface of the electronic boards.
- Fig. 4 illustrates a side view of the assembly of a surface mounted component on the electronic board according to the invention.
- Fig. 5 illustrates a view of a solder meniscus of the assembly of a surface mounted component on the electronic board according to the invention.

With reference to Figs. 2a and 2b, it may be observed that the interconnection support 101 of the electronic board 100 is provided with receiving pads 102 which provide the electrical connection with the surface mounted component 200. According to the prior art, these pads often are the only mechanical attachment support of the surface mounted component on the electronic board 100.

The mechanical stresses which appear in the service circumstances mentioned earlier are concentrated, as previously stated, in the areas of these electrical connection receiving pads 102, and more specifically in the solder or conducting adhesive joints which maintain both components 100 and 200 electrically assembled.

According to the present invention, an original implantation of surface mounted components on the support of an electronic board is proposed. On one hand, it reduces the concentration of mechanical stresses on the electrical connection receiving pads and on the other hand it reinforces the mechanical holding of the SMC casing component on the electronic board.

Referring now to Fig. 2a, a top view of the interconnection support 101 of the electronic board 100 is illustrated.

The type of support is not limited and includes any type of known printed circuit. It may be flexible, stiff, simple, double or multi-layered, all depends on the application.

In the figure, it is observed that the electronic board 100 consists of an interconnection support 101 provided on its upper face with two receiving pads 102 in order to achieve, preferably by soldering, electrical connections with the corresponding solderable electrical terminals 202 present on the lower face of the interposition sole 203 of the surface mounted component 200.

Preferably, the interconnection support is made out of copper deposited on an insulated substrate where copper electrical connection receiving pads are etched on its upper face or on its upper and lower faces.

The invention is not limited to the assembly of a surface mounted component on a conventional electrical connection receiving pad of an electronic board. The term used may refer to any type of support capable of receiving and establishing an electrical connection with an SMC type component.

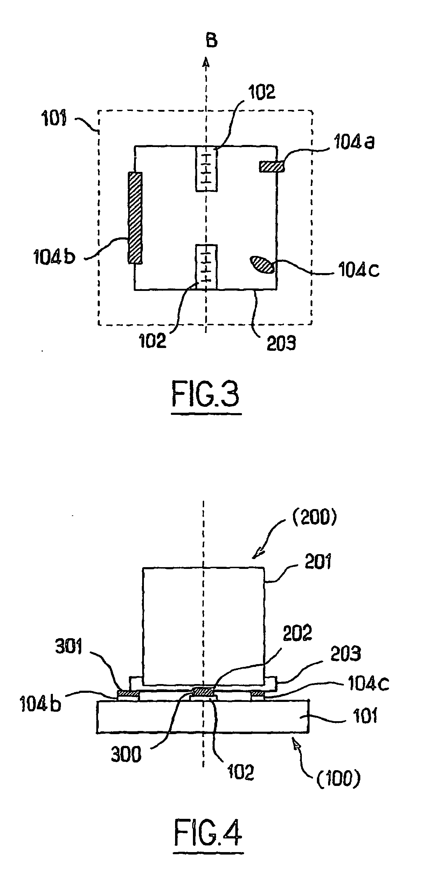

In Fig. 3, a middle axis B is referenced on the electrical connection receiving pads of the interconnection support.

Both electrical connection receiving pads 102 extend longitudinally along the B axis up to the limit of two opposite edges of the interposition sole 203 of the SMC type component.

As mentioned earlier, reinforcement of the mechanical holding of the surface mounted component on the interconnection support 101 of the electronic board is provided by the presence of at least one additional solderable holding pad 104 (104a, 104b or 104c) selectively positioned on the upper surface of the interconnection support 101.

Indeed, in the preferred embodiment of the invention, the solderable holding pads 104 are made outside axis B.

According to the principle of the invention, the solderable holding pads 104 are located in non-solderable areas of the lower surface of the sole 203 of the surface mounted component.

Preferably, they are etched in copper on the upper face of the interconnection support 101 of the electronic board 100.

A large variety of configurations of holding solder pads may be patterned on the free surfaces in order to optimize the mechanical reinforcement role, but also that of the manufacturing conditions. On the other hand, the number, the surface, the shape, the nature of the pads may be the object of many alternative embodiments. They are not limited to the illustrations given in the appended figures. In particular, provision may be made so that the solderable holding pads 104 are partly or entirely covered by the interposition sole 203 of the surface mounted component.

Now referring to Fig. 4, the surface mounted component intended to be implanted on the electronic board is considered.

It comprises a simple casing 201 for example containing, in a non-limiting way, a chemical capacitor. The latter is fixed onto the upper face of an interposition sole 203 substantially parallel and with a surface area identical with that of the lower face of the sole as for itself, intended to be assembled onto the upper face of the interconnection support 101 of the electronic board.

Preferably, the dimensions are standardized dimensions for surface mounted components of electronic boards well known to the skilled practitioner.

The electrical terminals 202 of the component are positioned on the lower face of the interposition sole 203.

On the other hand, an alternative embodiment of the invention which is distinct from the one illustrated in Fig. 2a, by the fact that the surface mounted component is provided with connection pins 204 intended to establish an electrical connection with the pads 102 for receiving the interconnection support of the electronic board, is illustrated in appended Fig. 2b.

The structures of the surface mounted components are well known to the skilled practitioner and will not be described in more detail.

The particular localization of solderable holding pads will allow the oscillations of the SMC case components to be reduced relatively to the electronic board in a severe environment of repeated vibrations and impacts on the one hand and the reliability of the system to be improved by improving the interconnection support/electronic components connections on the other hand.

Indeed, Fig. 4 illustrates, according to a preferred embodiment of the invention, the assembly of the SMC type component 200 with the electronic board 100.

According to the invention, a deposit solder is provided on the whole of the pads in order to effectively fix the surface mounted component to the interconnection support of the electronic board.

More specifically, by using a soldering mask, volumes of solder cream are automatically deposited by a depositing machine on the electrical connection receiving pad 102 and on the solderable holding pads 104 of the interconnection support 101 of the electronic board 100.

In the preferred embodiment of the invention, the whole of the pads is covered with solder alloy.

The surface mounted component 200 is assembled with the electronic board 100 by a pick-and-place machine. According to the invention, the SMC type component 200 rests with its electrical terminals 202 on the electrical connection receiving pads 102 of the interconnection support 101 and, in a non-solderable area of its interposition sole 203 on the solderable holding pads 104 as illustrated and discussed in Fig. 3.

The assembly is soldered by reflowing.

The SMC type component 200 is then held by solder joints 300 on the conducting receiving pads 102 and by mechanical solders 301 on the solderable holding pads 104.

In a preferred embodiment of the invention, the deposits of solders on the solderable holding pads 104 form menisci after reflow. It is recalled that solder menisci 301 do not have any electric connection effect, they come into contact with the interposition sole 203 of the surface mounted component 200 in a non-solderable area of the latter.

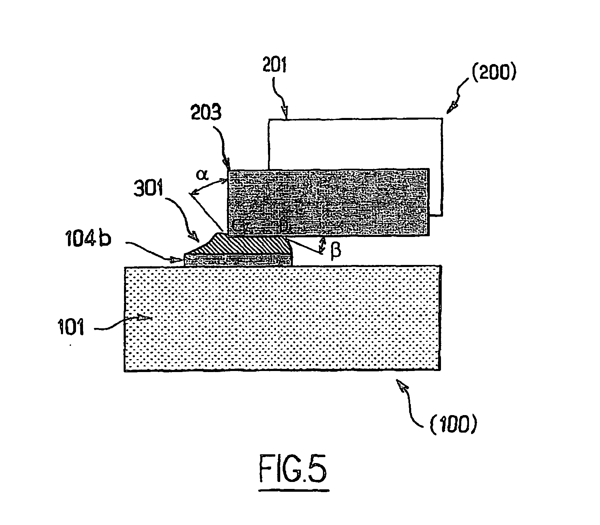

Two angles α and β are defined in Fig. 5 illustrating an exemplary solder meniscus. Angle α is the direct angle of the tangent of the solder meniscus to the point of contact C with the interposition sole 203 of the component 200 and β is the indirect angle of the tangent of the solder meniscus to the point of contact D with the interposition sole 203 of the component 200.

According to the invention, angles α and β are between 0° and 90°. It is thereby shown that there is no wettability of the alloy on the component. Therefore, the component 200 is not soldered at the level of the pads 104.

After assembly, according to the preferred embodiment of the invention, the surface mounted component is mechanically held by the solder joints 300 formed on its solderable electrical terminals 202 and by the solder menisci 301 formed on the solderable holding pad(s) 104 of the interconnection support 101.

As the solderable holding pads 104 of this original implantation are preferably located outside the middle axis B passing through the electric connection receiving pads 102 and partly or entirely under the interposition sole 203 of the electronic component, the oscillations of the electronic component relatively to the interconnection support are blocked and the resistance of the surface mounted component/electronic board assembly to repeated vibrations and impacts is increased.

Of course, the present invention is not limited to the particular embodiments which have just been described, but extends to any alternative in accordance with the scope of the appended claims. In particular, the present invention is not limited to the appended drawings. The specific references illustrated in the previous paragraphs are non-limiting examples of the invention.

The description is focussed on SMC type components (resistors, capacitors (either chemical or not), self-induction coils, transistors, integrated circuits, LEDs, switches, connectors, ...) which would most benefit from the advantages of the present invention. However, any electronic component may benefit from the implantation method according to the invention.

## Claims

1. A method for implantation of at least one electronic component (200) on a support (101) provided with electrical connection receiving pads (102), including a step for mechanically holding said electronic component on said support, **characterized in that** it said mechanical holding step being at least achieved by depositing solder (301) on at least one solderable holding pad (104a), distinct from the electrical connection and solder receiving pads on the electronic component, and by positioning said electronic component on said support so that said additional solderable holding pad comes at least partly into contact with a non-solderable area of said electronic component in order to obtain strong resistance to repeated vibrations and/or impacts.

2. The method according to the preceding claim 1, **characterized in that** said mechanical holding step being at least achieved by depositing solder on a unique solderable holding pad.

3. The method to the preceding claim 1, **characterized in that** said mechanical holding step being at least achieved by depositing solder on several solderable holding pads.

4. The method according to any of the preceding claims, **characterized in that** said solderable holding pads are located outside the middle axis (B) passing through the electric connection receiving pads.

5. The method according to any of the preceding claims, **characterized in that** said electronic component is a surface mounted component.

6. The method according to any of the preceding claims, **characterized in that** said electronic component is a surface mounted chemical capacitor.

7. The method according to any of the preceding claims, **characterized in that** said support is an electronic board.

8. The method according to any of the preceding claims, **characterized in that** said solder deposit, once reflowed, has the shape of a meniscus.

9. A system comprising at least one electronic component (200) and one support (101), provided with electrical connection receiving pads, **characterized in that** said electronic component is at least held on said support by a solder deposit (301) at the level of at least one solderable holding pad (104a), distinct from said electrical connection and solder receiving pads on the electronic component, and positioned on said support so that said additional solderable holding pad comes at least partly into contact with a non-solderable area of said electronic component in order to obtain a strong resistance to repeated vibrations and/or impacts.

10. The system according to the preceding claim 9, **characterized in that** said electronic component is at least held on said support by a solder deposit at a single solderable holding pad.

11. The system according to the preceding claim 9, **characterized in that** said electronic component is at least held on said support by a solder deposit at several solderable holding pads.

12. The system according to the preceding claims 9 to 11, **characterized in that** said solderable holding pads are located outside the middle axis (B) passing through the electrical connection receiving pads.

13. The system according to any of the preceding claims 9 to 12, **characterized in that** said electronic component is a surface mounted component.

14. The system according to any of the preceding claims 9 to 13, **characterized in that** said electronic component is a surface mounted chemical capacitor.

15. The system according to any of the preceding claims 9 to 14, **characterized in that** said support is an electronic board.

16. The system according to any of the preceding claims 9 to 15, **characterized in that** said solder deposit, once reflowed, has the shape of a meniscus.

## Patentansprüche

1. Verfahren zur Bestückung von mindestens einem elektronischen Bauelement (200) auf eine Auflage (101), ausgestattet mit elektrisch verbindenden Aufnahmeanschlüssen (102), das einen Schritt zum mechanischen Halten des elektronischen Bauelements auf der Auflage umfasst, **dadurch gekennzeichnet, dass**
der mechanische Halteschritt zumindest durch Auftragen von Lötmittel (301) auf mindestens einen lötbaren Halteanschluß (104a), der sich von den elektrisch verbindenden und Lötaufnahmeanschlüssen am elektronischen Bauelement unterscheidet und durch Positionieren des elektronischen Bauelements auf der Auflage erreicht wird, so dass der zusätzliche lötbare Halteanschluß zumindest teilweise mit einem nicht lötbaren Bereich des elektronischen Bauelements in Kontakt gerät, um einen hohe Festigkeit gegen wiederholte Erschütterungen und/oder Stöße zu erreichen.

2. Verfahren nach Anspruch 1, **dadurch gekennzeichnet, dass** der mechanische Halteschritt zumindest durch Auftragen von Lötmittel auf einen einzelnen lötbaren Halteanschluß erreicht wird.

3. Verfahren nach Anspruch 1, **dadurch gekennzeichnet, dass** der mechanische Halteschritt zumindest durch Auftragen von Lötmittel auf mehrere lötbare Halteanschlüsse erreicht wird.

4. Verfahren nach einem der vorhergehenden Ansprüche, **dadurch gekennzeichnet, dass** sich die lötbaren Halteanschlüsse außerhalb der durch die elektrisch verbindenden Aufnahmeanschlüsse führende Mittelachse (B) befinden.

5. Verfahren nach einem der vorhergehenden Ansprüche, **dadurch gekennzeichnet, dass** das elektronische Bauelement ein oberflächenmontiertes Bauelement ist.

6. Verfahren nach einem der vorhergehenden Ansprüche, **dadurch gekennzeichnet, dass** das elektronische Bauelement ein oberflächenmontierter chemischer Kondensator ist.

7. Verfahren nach einem der vorhergehenden Ansprüche, **dadurch gekennzeichnet, dass** die Auflage eine elektronische Platine ist.

8. Verfahren nach einem der vorhergehenden Ansprüche, **dadurch gekennzeichnet, dass** die Lötmittelauftragung, nach dem Aufschmelzen eine Meniskusform hat.

9. System, das mindestens ein elektronisches Bauelement (200) und eine mit elektrisch verbindenden Aufnahmeanschlüssen ausgestattete Auflage (101) aufweist, **dadurch gekennzeichnet, dass** das elektronische Bauelement zumindest auf der Auflage durch eine Lötmittelauftragung (301) auf der Höhe von mindestens einem lötbaren Halteanschluß (104a) gehalten wird, der sich von den elektrisch Verbindenden und Lötaufnahmeanschlüssen am elektronischen Bauelement unterscheidet, und auf der Auflage so angeordnet ist, dass der zusätzliche lötbare Halteanschluß zumindest teilweise mit einem nicht-lötbaren Bereich des elektronischen Bautelements in Kontakt gerät, um eine hohe Festigkeit gegen wiederholte Erschütterung und/oder Stöße zu erreichen.

10. System nach Anspruch 9, **dadurch gekennzeichnet, dass** das elektronische Bauelement auf der Auflage mindestens durch eine Lötmittelauftragung an einem einzelnen lötbaren Halteanschluß gehalten wird.

11. System nach Anspruch 9, **dadurch gekennzeichnet, dass** das elektronische Bauelement auf der Auflage mindestens durch eine Lötmittelauftragung an mehreren lötbaren Halteanschlüssen gehalten wird.

12. System nach den vorhergehenden Ansprüchen 9 bis 11, **dadurch gekennzeichnet, dass** sich die lötbaren Halteanschlüsse außerhalb der durch die elektrisch verbindenden Aufnahmeanschlüsse führende Mittelachse (B) befinden.

13. System nach einem der Ansprüche 9 bis 12, **dadurch gekennzeichnet, dass** das elektronische Bauelement ein oberflächenmontiertes Bauelement ist.

14. System nach einem der Ansprüche 9 bis 13, **dadurch gekennzeichnet, dass** das elektronische Bauelement ein oberflächenmontierter chemischer Kondensator ist.

15. System nach einem der Ansprüche 9 bis 14, **dadurch gekennzeichnet, dass** die Auflage eine elektronische Platine ist.

16. System nach einem der Ansprüche 9 bis 15, **dadurch gekennzeichnet, dass** die Lötmittelauftragung, nach dem Aufschmelzen eine Meniskusform hat.

## Revendications

1. Procédé d'implantation d'au moins un composant électronique (200) sur un support (101) muni de pastilles de réception de connexion électrique (102), comprenant une étape consistant à maintenir mécaniquement ledit composant électronique sur ledit support, **caractérisé en ce que** ladite étape de maintien mécanique est au moins réalisée en déposant un métal d'apport (301) sur au moins une pastille de maintien soudable (104a), différent des pastilles de réception de connexion électrique et de réception de métal d'apport, et en positionnant ledit composant électronique sur ledit support de sorte que ladite pastille de maintien soudable supplémentaire vienne au moins partiellement en contact avec une zone non soudable dudit composant électronique afin d'obtenir une résistance forte aux vibrations et/ou aux chocs répétés.

2. Procédé selon la revendication 1, **caractérisé en ce que** ladite étape de maintien mécanique est au moins réalisée en déposant un matériau d'apport sur une pastille de maintien soudable unique.

3. Procédé selon la revendication 1, **caractérisé en ce que** ladite étape de maintien mécanique est au moins réalisée en déposant un matériau d'apport sur plusieurs pastilles de maintien soudables.

4. Procédé selon l'une quelconque des revendications précédentes, **caractérisé en ce que** lesdites pastilles de maintien soudables sont situées à l'extérieur de l'axe médian (B) passant à travers les pastilles de réception de connexion électrique.

5. Procédé selon l'une quelconque des revendications précédentes, **caractérisé en ce que** ledit composant électronique est un composant monté en surface.

6. Procédé selon l'une quelconque des revendications précédentes, **caractérisé en ce que** ledit composant électronique est un condensateur chimique monté en surface.

7. Procédé selon l'une quelconque des revendications précédentes, **caractérisé en ce que** ledit support est une carte électronique.

8. Procédé selon l'une quelconque des revendications précédentes, **caractérisé en ce que** ledit dépôt de métal d'apport, une fois refondu, a la forme d'un ménisque.

9. Système comprenant au moins un composant électronique (200) et un support (101), muni de pastilles de réception de connexion électrique, **caractérisé en ce que** ledit composant électronique est au moins maintenu sur ledit support par un dépôt de métal d'apport (301) au niveau d'au moins une pastille de maintien soudable (104a), différente desdites pastilles de réception de connexion électrique et de réception de métal d'apport sur le composant électronique, et positionné sur ledit support de sorte que ladite pastille de maintien soudable supplémentaire vienne en contact avec une zone non soudable dudit composant électronique afin d'obtenir une résistance forte aux vibrations et/ou aux chocs répétés.

10. Système selon la revendication 9, **caractérisé en ce que** ledit composant électronique est au moins maintenu sur ledit support par un dépôt de métal d'apport au niveau d'une pastille de maintien soudable unique.

11. Système selon la revendication 9, **caractérisé en ce que** ledit composant électronique est au moins maintenu sur ledit support par un dépôt de métal d'apport au niveau de plusieurs pastilles de maintien soudables.

12. Système selon les revendications précédentes 9 à 11, **caractérisé en ce que** lesdites pastilles de maintien soudables sont situées à l'extérieur de l'axe médian (B) passant à travers les pastilles de réception de connexion électrique.

13. Système selon l'une quelconque des revendications 9 à 12, **caractérisé en ce que** ledit composant électronique est un composant monté en surface.

14. Système selon l'une quelconque des revendications 9 à 13, **caractérisé en ce que** ledit composant électronique est un condensateur chimique monté en surface.

15. Système selon l'une quelconque des revendications 9 à 14, **caractérisé en ce que** ledit support est une carte électronique.

16. Système selon l'une quelconque des revendications 9 à 15, **caractérisé en ce que** ledit dépôt de métal d'apport, une fois refondu, a la forme d'un ménisque.
